**Europäisches Patentamt**

(19) **European Patent Office**

**Office européen des brevets**

(11) Veröffentlichungsnummer: **0 016 858**
**B1**

(12) **EUROPÄISCHE PATENTSCHRIFT**

(45) Veröffentlichungstag der Patentschrift:
**23.06.82**

(21) Anmeldenummer: **79104633.7**

(22) Anmeldetag: **21.11.79**

(51) Int. Cl.³: **H 01 L 41/08, G 01 P 15/08,**
**G 01 L 1/16, G 01 L 9/08**

(54) Piezoelektrisches Wandlerelement zum Einbau in Druck-, Kraft- oder Beschleunigungsaufnehmer.

(30) Priorität: **20.02.79 DE 2906407**

(43) Veröffentlichungstag der Anmeldung:
**15.10.80 Patentblatt 80/21**

(45) Bekanntmachung des Hinweises auf die Patenterteilung:
**23.06.82 Patentblatt 82/25**

(84) Benannte Vertragsstaaten:
**AT CH DE FR GB**

(56) Entgegenhaltungen:
**CH-A-447 679**
**DE-A-1 773 551**
**DE-A-2 712 359**
**DE-B-1 929 479**
**US-A-3 725 986**

(73) Patentinhaber: **Kistler Instrumente AG,**
**Eulachstrasse 22, CH-8408 Winterthur (CH)**

(72) Erfinder: **Sonderegger, Conrad, Sonnhaldenstrasse 7,**
**CH-8413 Neftenbach (CH)**
Erfinder: **Sonderegger, Hans-Conrad, Dipl.-Ing.,**
**Sonnhaldenstrasse 7, CH-8413 Neftenbach (CH)**
Erfinder: **Boltshauser, Werner, Seenerstrasse 184,**
**CH-8405 Winterthur (CH)**

(74) Vertreter: **Schmidt, Horst, Dr. et al, Patentanwälte**
**Pohlmann & Schmidt Siegfriedstrasse 8,**
**D-8000 München 40 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Piezoelektrisches Wandlerelement zum Einbau in Druck-, Kraft- oder Beschleunigungsaufnehmer

Die Erfindung betrifft ein piezoelektrisches Wandlerelement zum Einbau in Druck-, Kraft- oder Beschleunigungsaufnehmer, mit wenigstens zwei auf Scherung beanspruchten planbearbeiteten Piezoplatten, die beidseitig eines zentralen Trägers angeordnet sind, und zwei außen an den Piezoplatten anliegenden kreissegmentförmigen Druckverteilungsstücken, wobei die Anordnung aus Druckverteilungsstücken, Piezoplatten und Träger durch ein aufgeschrumpftes Kompressionsformstück unter Vorspannung zusammengehalten ist.

In der Meßtechnik werden piezoelektrische Wandlerelemente zur Messung von mechanischen Schwingungen, Kräften und Drücken, also zur Messung mechanischer Größen, seit Jahrzehnten erfolgreich eingesetzt. Dazu sind die Wandlerelemente in zumeist vollständig abgeschlossenen Beschleunigungs- oder Schwingungs- bzw. Kraft- oder Druckaufnehmergehäusen eingebaut. Diese Meßwertaufnehmer sind mit entsprechenden Montageorganen, Krafteinleitungsflächen und Druckbeaufschlagungs-Membranen versehen sowie mit Anschlüssen zur Abnahme des Meßsignals ausgerüstet, so daß sie je nach Verwendungszweck ganz verschiedene äußere Formen aufweisen. Von Bedeutung ist aber, daß das Wandlerelement in allen Fällen die gleiche Aufgabe besitzt, nämlich eine mechanische Kraft in ein proportionales elektrisches Signal umzuwandeln. Zwar ist immer wieder versucht worden, ein Einheits-Wandlerelement zu schaffen, das sich zum Einbau in alle Meßwertaufnehmer zur Messung mechanischer Größen verwenden läßt, doch haben diese Versuche bisher nicht zu einem universell einsetzbaren Wandlerelement geführt, das sich in Serie herstellen und für alle erwähnten Meßwertaufnehmer ohne große Anpassungsarbeiten verwenden läßt.

Bekannt sind Wandlersysteme, bei welchen die Massensegmente, die Piezoplatten und der Träger mit einer Bohrung versehen sind, durch welche eine Schraube geführt ist, die das ganze System unter mechanische Vorspannung versetzt. Obwohl eine solche Anordnung vom Aufbau sehr einfach ist, hat sie den Nachteil, daß die Piezoplatten mit Bohrungen versehen werden müssen, was ihre Rißanfälligkeit wesentlich erhöht und ferner die Gefahr von Kurzschlüssen entlang der Schraubenbohrungen hervorruft.

Bekannt sind weiter verschiedene piezoelektrische Wandlersysteme, die nach dem Scherprinzip arbeiten. Bei der Anordnung nach der DE-OS 2 712 359 sind zwei auf Scherung beanspruchte, rechteckige Piezoplatten vorgesehen, die beidseitig eines flachen zentralen Blechträgers angeordnet sind und an denen weiter je ein kreissegmentförmig gestaltetes Druckverteilungsstück anliegt. Die Anordnung aus Piezoplatten, Druckverteilungsstücken und Träger wird durch einen sie außen umgreifenden Federring zusammengehalten, der die Piezoplatten einer gewissen Vorspannkraft aussetzt. Der dünne Träger bewirkt eine schlechte Ankopplung des Piezosystems an eine Aufnehmergrundplatte mit entsprechend niedriger Eigenfrequenz. Des weiteren ist ein Federring zu elastisch, um die Piezoplatten mit einem für die Übertragung großer Schubkräfte notwendig hohen Anpreßdruck vorzuspannen, so daß sich das bekannte Wandlerelement nur für einen Einsatz bei relativ niedrigen Umgebungstemperaturen eignet.

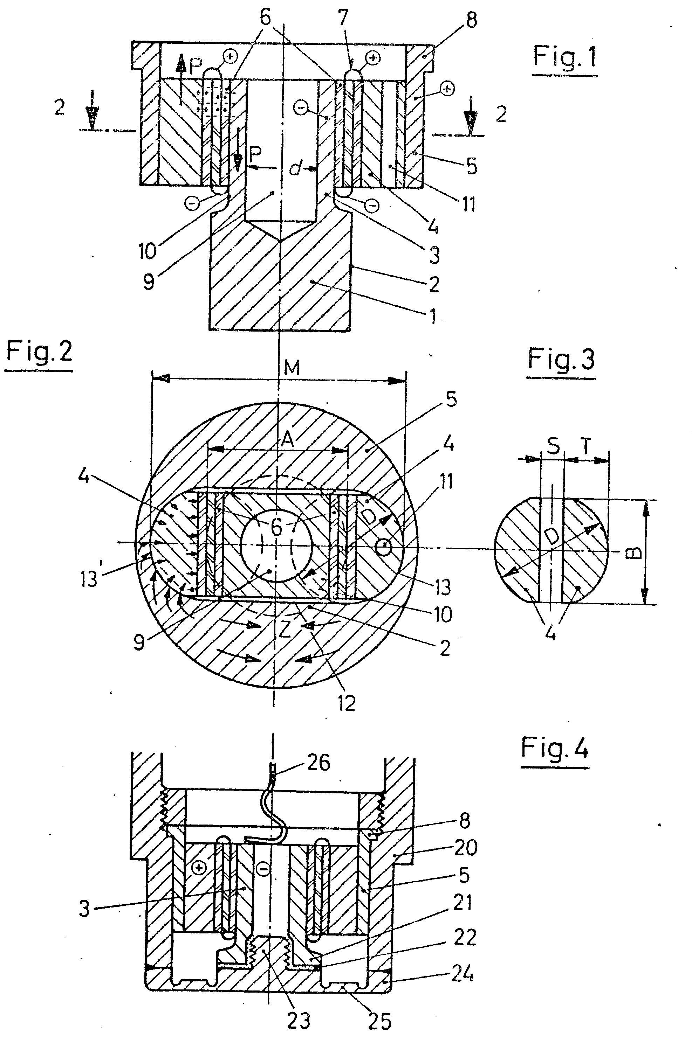

Zwar wird in Anbetracht dieser Nachteile in der US-PS 3 725 986 schon vorgeschlagen, anstelle eines Federringes die ansonsten unveränderte Anordnung aus Piezoplatten, Druckverteilungsstücken und dünnem Blechträger durch ein auf die Druckverteilungsstücke aufgeschrumpftes Kompressionsformstück zusammenzuhalten, so daß wesentlich höhere Vorspannkräfte zur Wirkung kommen. Mit dieser bekannten Maßnahme ist jedoch keine gleichmäßige Druckverteilung senkrecht zu den Kristallflächen erzielbar, da die Piezoplatten, Druckverteilungsstücke und der Blechträger in einer kreisförmigen Bohrung im Kompressionsformstück aufgenommen sind. Die Bohrung in Verbindung mit dem restlichen Querschnitt des Kompressionsformstückes schafft keine definierten Kraftflußzonen (vgl. dagegen Fig. 2). Infolge der ungleichmäßigen Druckverteilung führen die hohen Vorspannkräfte leicht zu Kristallbrüchen, insbesondere an den Kanten der Piezoplatten, die aufgrund der kreisförmigen Ausbildung der Aufnahmebohrung hohen radialen Druckspannungen ausgesetzt sind. Im übrigen hat der dünne Blechträger zur Folge, daß das Wandlerelement eine viel zu niedrige Eigenfrequenz aufweist, um für Beschleunigungsmessungen in Frage zu kommen.

Demgegenüber liegt der Erfindung die Aufgabe zugrunde, ein Wandlerelement der eingangs erwähnten und aus der US-PS 3 725 986 bekannten Gattung zu schaffen, bei dem trotz Anwendung der Schrumpftechnik und der damit verbundenen Einsatzmöglichkeit auch bei hohen Betriebstemperaturen eine definierte, gleichmäßige Druckbeaufschlagung der Piezoplatten gewährleistet ist.

Diese Aufgabe wird erfindungsgemäß dadurch gelöst, daß die Anordnung aus Druckverteilungsstücken, Piezoplatten und Träger in einem im Kompressionsformstück ausgebildeten Langloch aufgenommen ist, das dem Krümmungsradius der Druckverteilungsstücke angepaßte Rundenden hat.

Im Gegensatz zu der bei dem bekannten Wandlerelement verwendeten kreisförmigen Bohrung ist somit die Anordnung aus Druckverteilungsstücken, Piezoplatten und Träger erfindungsgemäß in einem Langloch aufgenommen, das den Querschnitt des Kompressionsformstückes, insbesondere in Verbindung mit dem Merkmal des Unteranspruchs 2, in eine voluminöse, kräftige Zugzone und eine elastische Umleit- oder Verteilzone unterteilt. Die auf die Druckverteilungsstücke einwirkenden Druckspannungen werden daher in optimaler Weise auf die Druckverteilungsstücke mit der Folge eingeleitet, daß die Piezoplatten über ihre gesamte Fläche einer gleichmäßigen Beanspruchung senkrecht zu den Kristallflächen ausgesetzt sind. Kristallbrüche infolge nicht homogener Spannungsverteilung können daher bei dem erfindungsgemäßen Wandlerelement nicht mehr auftreten.

Ein weiterer mit dem Vorsehen des Langloches zur Aufnahme der Anordnung aus Piezoplatten, Druckverteilungsstücken und Träger verbundener Vorteil besteht darin, daß hinsichtlich der Dicke des Trägers keine Beschränkungen vorliegen, so daß dieser die für Beschleunigungsmessungen erforderliche massive Querschnittskonfiguration gemäß der Weiterbildung nach Unteranspruch 5 haben kann. Das Wandlerelement läßt sich daher infolge der hohen Eigenfrequenz nicht nur für statische Druck- und Kraftmessungen, sondern auch für Beschleunigungsmessungen und damit universell einsetzen.

Gemäß einer bevorzugten Weiterbildung der Erfindung ist der Abstand der Mittelpunkte der beiden die Rundenden des Langloches bildenden Bohrungen größer als deren Durchmesser, d. h. bei der Herstellung des Langloches werden die beiden Bohrungen in Vollmaterial eingebracht, worauf man den verbleibenden Steg zwischen den Bohrungen unter Bildung des fertigen Langloches ausfräst oder erodiert. Die Anpassung der Rundenden des Langloches an den Krümmungsradius der Druckverteilungsstücke kann somit leicht mit der notwendigen Toleranz in Serienfertigung erzielt werden.

Durch die Erfindung wird somit ein piezoelektrisches Wandlerelement bereitgestellt, das universell sowohl für Druck-, Kraft- als auch Beschleunigungsmessungen verwendet werden kann und insbesondere, wenn auch nicht ausschließlich, für den Einsatz bei höheren Temperaturen geeignet ist. Besonders in Temperaturbereichen von z. B. 600° C ist eine perfekte, verzugsfreie Kristallauflage und eine sehr hohe, möglichst einachsige und gleichmäßige Verspannung der Kristalle Voraussetzung. Die Kombination eines aufgeschrumpften, massiven und verformungssteifen Kompressionsformstücks mit einer Ausbildung des Aufnahmeloches in Form von einem definierten Langloch ermöglicht eine Beaufschlagung der Piezoplatten mit einer gleichmäßig verteilten spezifischen Flächenspannung von z. B. 30 kp/mm² und mehr.

Gegenstand der Erfindung sind weiter die nachfolgend aufgeführten Ausbildungen von mit dem erfindungsgemäßen Wandlerelement ausgestatteten Meßwertaufnehmern.

Ausführungsformen der Erfindung werden nachfolgend anhand der Zeichnung näher erläutert. Es zeigt

Fig. 1 eine längsgeschnittene Ansicht von einem erfindungsgemäß aufgebauten Wandlerelement, insbesondere geeignet für den Einbau in Druckaufnehmern,

Fig. 2 einen Schnitt längs der Schnittlinie 2-2 in Fig. 1,

Fig. 3 eine geschnittene Ansicht zur Darstellung der Ausbildung und Anfertigung der Druckverteilungsstücke,

Fig. 4 eine bevorzugte Ausführungsform von einem mit einem Wandlerelement nach der Erfindung versehenen Druckaufnehmer,

Fig. 5 eine bevorzugte Ausführungsform von einem mit einem modifizierten Wandlerelement nach der Erfindung versehenen Beschleunigungsaufnehmer mit spezieller Abschirmung,

Fig. 6 einen Schnitt längs der Schnittlinie 6-6 in Fig. 5,

Fig. 7 eine perspektivische auseinandergezogene Teilansicht von einem erfindungsgemäß aufgebauten Wandlerelement für die Beschleunigungsmessung in drei orthogonalen Koordinatrichtungen X, Y, Z, wobei das Kompressionsformstück als seismische Masse dient.

Beim piezoelektrichen Wandlerelement nach der vorliegenden Erfindung werden anstelle von zylindrischen Piezoelementen planbearbeitete Piezoplatten verwendet. Es hat sich gezeigt, daß für Anwendungen in Temperaturbereichen von über 400° C planbearbeitete Piezoplatten und ebenso bearbeitete Auflageflächen besser geeignet sind.

Der Aufbau des erfindungsgemäßen Wandlerelements ist in Fig. 1, 2 und 3 dargestellt. Ein Befestigungsteil 1 besteht vorzugsweise aus einer temperaturbeständigen Ni-Legierung, z. B. Nimonic, und umfaßt einen zylindrischen Paßkolben 2. Am Paßkolben 2 ist, wie dargestellt, z. B. durch Fräsen, ein rechteckförmiger Ansatz oder Träger 3 für die Piezoplatten mit zwei planparallel geschliffenen gegenüberliegenden Druckflächen 10 angeformt. Der Durchmesser d einer zentrisch im Träger 3 eingebrachten Bohrung 9 ist von großer Bedeutung zur Erzeugung der notwendigen Elastizität und zur Gewährleistung der gewünschten Formtreue der Druckflächen 10 unter verschiedenen Temperaturbedingungen. Als Piezoelement dient mindestens eine an jeder Druckfläche 10 anliegende planparallele Piezoplatte 6, die bei Einwirken einer axialen Scherbeanspruchung P (vgl. Fig. 1) in bekannter Weise, je nach Richtung der Kraft P, negative oder positive Ladungen an den Piezoträger 3 abgibt. Im gezeigten Beispiel sind je drei Piezoplatten 6 vorgesehen, zwischen denen in bekannter Weise Elektroden 7 eingelegt sind. Gewöhnlich werden diese Elektroden aus dünnen Metallfolien ausgestanzt und bei der Montage eingelegt. Anstelle der Metallfolien können jedoch auch Metallbeschichtungen direkt auf den Piezoplatten 6 aufgetragen sein. Die Erfahrung hat aber gezeigt, daß die von der Halbleitertechnik übernommenen Verbindungsmethoden für Anwendung bei hohen Temperaturen eingelegten Metallfolien unterlegen sind.

Als Piezoplatten 6 können sowohl piezokeramische wie auch solche aus Einkristallen Verwendung finden. Geeignete Einkristallmaterialien sind Quarzkristall, Turmalin, Lithiumniobat, Lithiumtantalat und andere. Die Orientierung solcher Kristallplättchen für Axialscherbeanspruchung ist dem Fachmann bekannt; es braucht daher darauf nicht näher eingegangen zu werden.

Wie dargestellt, umfaßt die vorbeschriebene Anordnung weiter zwei Druckverteilungsstücke 4, die vorzugsweise durch Auftrennung eines gemäß Fig. 3 durch z. B. Überschleifen an zwei diametral gegenüberliegenden Stellen abgeflachten Bolzens mit dem Durchmesser D gebildet werden, so daß zwei im wesentlichen halbkreisförmige Segmente entstehen. Der diametrale Abstand der beiden abgeflachten Bereiche hat einen geeigneten Wert B, der der Breite der Piezoplatten 6 entspricht. Die mit den Piezoplatten 6 in Berührung kommenden Auflageflächen der Druckverteilungsstücke 4 sind weiter auf ein Toleranzmaß T planbearbeitet (vgl. Fig. 3). Je ein solches Druckverteilungsstück 4 ist, wie in Fig. 1 und 2 gezeigt, an der dem Ansatz 3 abgewandten Seite der betreffenden Piezoplatte 6 angeordnet, so daß diese zwischen den beiden Stücken eingeschlossen wird. Vorteilhafterweise sind die Druckverteilungsstücke 4 noch mit Montagebohrungen 11 (nur eine ist in Fig. 2 gezeigt) versehen, die es gestatten, die Piezoplatten 6 über die Druckverteilungsstücke 4 an dem Träger 3 zu heften, wobei eine bestimmte Minimalvorspannung eingehalten werden sollte. Hierauf kann das für den nachfolgend näher beschriebenen Schrumpfvorgang wichtige Hauptmaß M an der so vormontierten Anordnung längs ihrer längeren Hauptachse abgenommen werden (vgl. Fig. 2).

Wie in Fig. 1 und 2 weiter gezeigt, ist ein von der Struktur her massives und verformungssteifes Kompressionsformstück 5 mit vorzugsweise kreisförmigem Querschnitt vorgesehen, das ebenfalls aus einer temperaturbeständigen Legierung, wie Nimonic oder Inconel, bestehen kann und ein zu seinen Hauptachsen mittig ausgerichtetes Langloch 12 mit einem zentralen rechteckförmigen Abschnitt A, an dem sich beidseitig kreissegmentförmige Abschnitte 13, 13' bündig anschließen, aufweist. Hierzu kann ein kreisförmiger Vorformling auf einer Koordinatenbohrmaschine aufgespannt und in einem Mittenabstand A längs einer Hauptachse des Vorformlings je eine Bohrung mit dem Durchmesser D (vgl. Fig. 3) eingebracht werden, worauf man den verbleibenden Steg zwischen den Bohrungen auf eine Breite entsprechend D ausfräst oder erodiert. Dabei entstehen Gruppen von Kompressionsformstücken 5, die verschiedene Toleranzmassen M gemäß Fig. 2 aufweisen.

Bei der Montage werden die, wie vorerwähnt, vormontierten Anordnungen, bestehend aus Befestigungsteil 1, Piezoplatten 6 und Druckverteilungsstücken 4, in Gruppen mit ähnlichem Hauptmaß M ausgewählt und Paare aus Kompressionsformstücken 5 und vormontierten vorerwähnten Anordnungen miteinander angepaßtem vorgeschriebenem Schrumpfübermaß zusammengestellt. Dann wird das Kompressionsformstück 5 erhitzt und entsprechend Fig. 2 über die vormontierte Anordnung geschoben und anschließend nach bekannten Methoden der Schrumpftechnik abgekühlt. Nach Temperaturausgleich liegt ein piezoelektrisches Wandlerelement vor, das infolge der durch das aufgeschrumpfte verformungs- bzw. federsteife Kompressionsstück 5 erzeugten hohen Flächenpressung hohe Scherkräfte in einem weiten Temperaturbereich übertragen kann. Durch die beschriebene erfindungsgemäße Gestaltung des Kompressionsformstückes 5 wird eine symmetrische Kraftübertragung auf die Druckverteilungsstücke 4 erreicht, welche die aus dem Schrumpfungsprozeß resultierenden Zugkräfte Z gleichmäßig auf die Piezoplatten 6 und den Piezoträger 3 verteilen; der Kraftkreis ist damit auf engstem Weg geschlossen. Zum Einbau in Druck- und Kraftaufnehmer kann das Kompressionsformstück 5 vorteilhafterweise mit einem Außenumfangsflansch 8 versehen werden (vgl. Fig. 1).

Fig. 4 zeigt den Einbau des erfindungsgemäßen piezoelektrischen Wandlerelements in einen Druckaufnehmer. Der Flansch 8 des Kompressionsformstückes 5 ist dabei im Druckaufnehmergehäuse 20 in bekannter Weise, z. B. durch einen in der Gehäusebohrung eingeschraubten Gewindering, verspannt. Eine an einem Ende des Gehäuses bei 24 befestigte oder angeschweißte Membran 25 weist in ihrer Mitte einen Stempel 23 auf, der mit einer Isolierschicht 22 versehen und mit dem hier verkürzten Paßkolben 2 des Wandlerelements, der als Druckübertragungskolben dient, z. B. durch eine Schraubverbindung verbunden ist. Als Isolation 22 eignen sich aufgespritzte Metalloxidbeschichtungen, z. B. aus $Al_2O_3$ oder $MgO$, die nach bekannten Plasma- oder Flammspritzverfahren auf die betreffenden Metalloberflächen aufgespritzt werden.

Die Signalableitung vom Piezoträger 3 erfolgt mittels einer Elektrode 26, die zu einem nicht gezeigten Anschlußstecker führt. Durch die sehr starre Ankopplung des Druckübertragungskolbens 2 an das Kompressionsformstück 5 ergibt sich ein Druckaufnehmer mit hoher Eigenfrequenz.

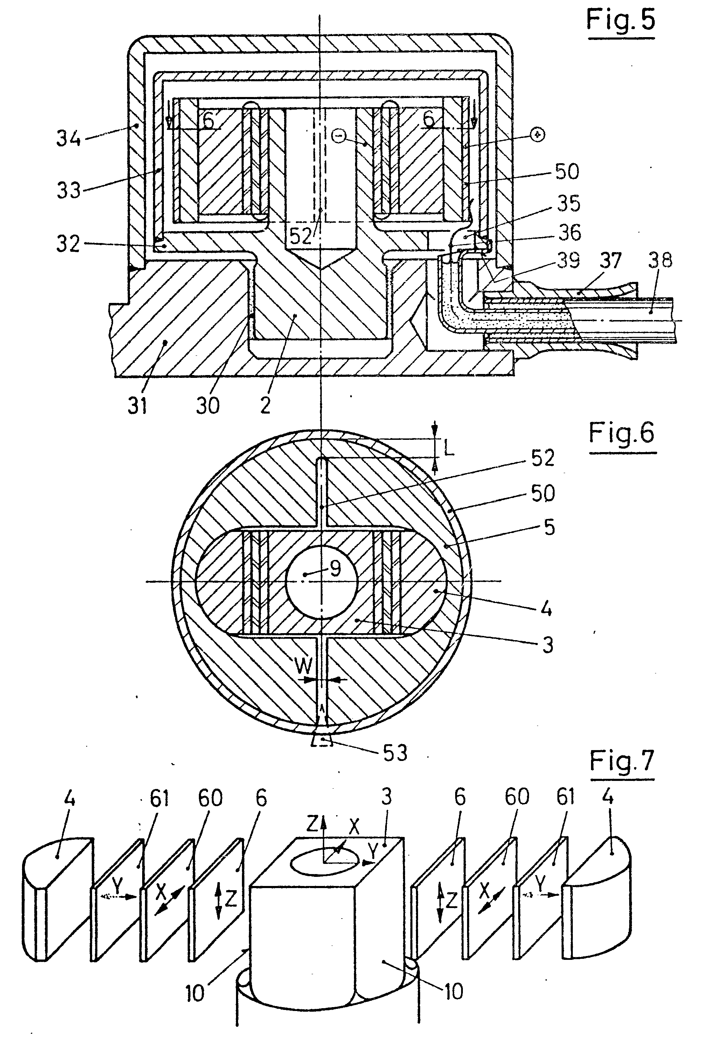

Fig. 5 zeigt ein Anwendungsbeispiel eines erfindungsgemäßen piezoelektrischen Wandlerelements in einem voll abgeschirmten und grundisolierten Beschleunigungsaufnehmer. Solche Aufnehmer können z. B. für Überwachungszwecke in Reaktoranlagen, Flug- und Stationärturbinen Anwendung finden. Fig. 6 zeigt das in Fig. 5 vorgesehene piezoelektrische Wandlerelement im Grundriß.

Nach Fig. 5 und 6 ist der Paßkolben 2 des erfindungsgemäßen Wandlerelements mit einer Isolierschicht 30 versehen und in das Aufnehmergehäuse 31 nach bekannten Methoden eingeschrumpft. Die Isolierschicht kann, wie oben in Verbindung mit Fig. 4 erwähnt, aufgebracht werden. Nach dem Aufspritzen der Isolierschicht wird der Paßkolben 2 auf Schrumpfmaß überschliffen. Anders als bei der Ausführungsform nach Fig. 1, 2 ist hier am Befestigungsteil im Bereich der Übergangsstelle von Paßkolben 2 und Piezoträger 3 ein horizontal nach außen sich erstreckender Schirmflansch 32 angeformt, an dem eine Abschirmhaube 33 befestigt ist, die die Piezoplatten und zugehörigen Teile nach außen hin vollständig abdeckt. Damit sind die ladungsführenden Teile des Wandlerelements gegenüber dem Gehäuse vollständig nach dem Prinzip eines Faradayschen Käfigs abgeschirmt. Magnetische und elektrische Felder sowie Potentialdifferenzen zwischen Aufnehmergehäuse und dem Gehäuse einer Signalverarbeitungseinrichtung haben daher keinen Einfluß auf das Meßsignal, so daß solche Aufnehmer in gedrängten Anlagen eingebaut werden können, wo Meß- und Befehlsleitungen in großer Zahl nebeneinander liegen.

Bei Verwendung des erfindungsgemäßen Wandlerelements in Beschleunigungsaufnehmern kann das Kompressionsformstück 5, das gleichzeitig die seismische Masse darstellt, vorteilhafterweise aus einer Schwermetallegierung mit einem spezifischen Gewicht von ca. 20, anstelle von Nimonic mit ca. 8,0, bestehen. Allerdings haben solche Schwermetallegierungen den Nachteil, daß sie in höheren Temperaturbereichen zwar hohe Druckkräfte, jedoch nur mäßige Zugkräfte übertragen können. Für Anwendungen über 400°C empfiehlt es sich deshalb, das Kompressionsformstück 5 gemäß Fig. 6 aus einer Schwermetallegierung herzustellen, wobei zusätzlich ein Längsschlitz 52 quer bzw. senkrecht zur Längsrichtung des Langloches in das Kompressionsformstück 5 mit einer Breite W und bis zu einer Resttiefe L eingefräst wird. Damit kann die Vormontage des Befestigungsteiles 1 mit den Piezoplatten 6, Elektroden 7 und Druckverteilungsstücken 4 ohne zusätzliche Montagehilfsmittel erfolgen, indem man den Schlitz 52 mit einem Montagekeil 53 etwas öffnet, worauf das Kompressionsformstück 5 über die Druckverteilungsstücke 4 geschoben werden kann. Nach Kontrolle der Lage der Piezoplatten und Elektroden wird der Montagekeil 53 weggenommen, worauf die Klemmwirkung die montierte Einheit zusammenhält. Hierauf wird ein passender Schrumpfring 50, z. B. aus Nimonic, nach bekannten Methoden der Schrumpftechnik erhitzt und aufgeschrumpft. Danach wird das Wandlerelement wiederum nach bekannten Methoden der Schrumpftechnik in das Aufnehmergehäuse 31 eingesetzt. Nach Einführung eines abgeschirmten Signalkabels 36 durch eine Leitungsdurchführung 35 im Flansch 32 und Verbindung des Signalkabels 36 mit dem Schrumpfring 50 kann die Abschirmhaube 33 aufgesetzt werden. Danach wird die Kabelabschirmung 39 mit der Abschirmhaube 33 verbunden, worauf ein äußerer Gehäusedeckel 34 mit dem Gehäuse 31 verschweißt wird. Zum Anschluß eines so abgeschirmten und grundisolierten Aufnehmers ist ein Metallkabel 38 nötig, das in verschiedenen Größen im Handel ist. Das fertig vorbereitete Kabelende wird in einen Kabelflansch 37 eingeschweißt, der seinerseits mit dem Gehäuse 31 verschweißt ist.

Es versteht sich jedoch, daß das erfindungsgemäße piezoelektrische Wandlerelement auch ohne Grundisolation in einen Beschleunigungsaufnehmer eingebaut werden kann. Auch kann dazu ein Kompressionsformstück 5 ohne Schlitz 52 verwendet werden, wie in Fig. 2 gezeigt. Für Temperaturbereiche bis 400° C existieren geeignete Schwermetallegierungen, während oberhalb dieser Temperatur Ni-Legierungen als Masse verwendet werden sollten, was zur Folge hat, daß sich kleinere Meßsignale oder größere Aufnehmervolumen ergeben.

In Fig. 7 ist eine weitere Variante des erfindungsgemäßen piezoelektrischen Wandlerelements gezeigt. Anstelle der in Fig. 1 und 5 gezeigten Anordnungen, bei denen alle Piezoplatten auf Scherkräfte in Axial- oder Z-Richtung des Wandlers empfindlich sind und wo entsprechende Elektroden und Verbindungsmittel zur Summierung der Einzelplattensignale vorgesehen sind, werden in Fig. 7 andere Ziele verfolgt. Es sind in dem gezeigten Beispiel nur zwei symmetrisch zum Träger 3 an dessen Druckflächen 10 anliegende Z-Piezoplatten 6 vorgesehen, während zwei weitere Platten 60, die ebenfalls auf Scherbeanspruchung ausgelegt sind, um 90° verdreht angeordnet sind, so daß sie auf Kräfte in X-Richtung ansprechen.

Ferner sind zwei weitere Platten 61 vorgesehen, die jedoch auf Druck senkrecht zur Plattenoberfläche ansprechen. Die zu einer solchen Plattenanordnung notwendigen Elektroden und Isolierplatten sind dem Fachmann bekannt. Nach Montage dieser Anordnung, wie oben beschrieben, entsteht ein Beschleunigungsaufnehmer, der in den drei auf den Wandler bezogenen orthogonalen Achsen X, Y, Z empfindlich ist und dementsprechend drei separate Signalableitungen aufweist. Diese sowie auch die Abnahmeelektroden, Abschirmungen und Isolatoren sind in Fig. 7 nicht eingezeichnet, da deren Anordnungen dem Fachmann bekannt sind.

Das erfindungsgemäße piezoelektrische Wandlerelement, das ohne Schrauben und ohne jedes Klebemittel auskommt, jedoch extrem hohe Flächenspannungen erreicht, eröffnet somit neue Möglichkeiten im Bau von piezoelektrischen Meßwandlern. Die einfache symmetrische Formgebung ermöglicht mit bekannten Bearbeitungsverfahren die Schaffung hochpräziser Wandlerelemente, die für verschiedene Anwendungszwecke optimiert werden können. Als Grundlage dient eine einachsige, jeweils aus zwei symmetrischen Piezoanordnungen bestehende, unter hoher Spannung stehende Kompressionskolonne, die vollständig in ein scheibenförmiges Kompressionsformstück 5 eingebaut ist. Dieses Kompressionsformstück 5 dient zwei Zwecken: erstens der internen Piezoverspannung, zweitens im Verwendungsfall von Druck- und Kraftaufnehmern zur Kraftübertragung und Halterung sowie im Fall von Beschleunigungsaufnehmern als seismische Masse. Wenn als seismische Masse verwendet, kann es aus einem legierten Stahl oder aus einer Schwermetallegierung bestehen. Je nachdem wird die Bohrung 9 zu dimensionieren sein, da eine Schwermetallegierung wesentlich starrer ist und wesentlich geringere Ausdehnung besitzt als bekannte Ni- oder Fe-Legierungen. Die Abstimmung der Elastizitäten und Ausdehnungskoeffizienten von Piezoträger 3, Piezoplatten 6 und Druckverteilungsstücken 4 auf diejenige des Kompressionsformstückes 5 und gegebenenfalls auf den Schrumpfring 50 erfolgt rechnerisch und versuchsmäßig, insbesondere was das erforderliche Schrumpfmaß betrifft. Dabei spielt auch der Durchmesser d der Bohrung 9 eine wichtige Rolle.

Als Anwendungsbeispiele des erfindungsgemäßen Wandlerelements wurde auf einen Druckaufnehmer und einen Beschleunigeraufnehmer hingewiesen. Ähnlich ist auch die Anwendung im Kraftaufnehmer. Varianten, das Wandlerelement auf einfache Weise in grundisolierten Aufnehmern oder mit Faradayschem Käfig zu versehen, sind aufgezeigt.

Die Erfindung ermöglicht somit, nach dem Kombinations- und Optimierungsprinzip, ausgehend von einem Grundkonzept, eine Reihe von anwendungstechnisch neuen verschiedenen Möglichkeiten.

Bei den vorerwähnten temperaturbeständigen Werkstoffen Nimonic und Inconal handelt es sich um Legierungen auf Basis NiCr oder NiCrCo oder NiCrCoMo mit Zusätzen an Fe, Al, Ti und anderen Bestandteilen.

## Patentansprüche

1. Piezoelektrisches Wandlerelement zum Einbau in Druck-, Kraft- oder Beschleunigungsaufnehmer, mit wenigstens zwei auf Scherung beanspruchten planbearbeiteten Piezoplatten, die beidseitig eines zentralen Trägers angeordnet sind, und zwei außen an den Piezoplatten anliegenden kreissegmentförmigen Druckverteilungsstücken, wobei die Anordnung aus Druckverteilungsstücken, Piezoplatten und Träger durch ein aufgeschrumpftes Kompressionsformstück unter Vorspannung zusammengehalten ist, dadurch gekennzeichnet, daß die Anordnung aus Druckverteilungsstücken (4), Piezoplatten (6) und Träger (3) in einem im Kompressionsformstück (5) ausgebildeten Langloch (12) aufgenommen ist, das dem Krümmungsradius der Druckverteilungsstücke angepaßte Rundenden hat.

2. Wandlerelement nach Anspruch 1, dadurch gekennzeichnet, daß der Abstand (A) der Mittelpunkte der beiden die Rundenden des Langloches (12) bildenden Bohrungen größer als deren Durchmesser (D) ist.

3. Wandlerelement nach Anspruch 1 oder 2, dadurch gekennzeichnet, daß das Kompressionsformstück (5) einen im wesentlichen kreisförmigen Außenumfang aufweist.

4. Wandlerelement nach Anspruch 1, 2 oder 3, dadurch gekennzeichnet, daß die Druckverteilungsstücke (4) diametral gegenüberliegende Abflachungen haben.

5. Wandlerelement nach Anspruch 1, 2, 3 oder 4, dadurch gekennzeichnet, daß der Träger (3) ein rechteckförmiger Block mit einer zentralen Bohrung (9) ist, deren Durchmesser (d) auf eine optimale Elastizitätsanpassung abstimmbar ist.

6. Wandlerelement nach Anspruch 5, dadurch gekennzeichnet, daß am Träger (3) ein Paßkolben (2) angeformt ist.

7. Wandlerelement nach einem der vorhergehenden Ansprüche, dadurch gekennzeichnet, daß das Kompressionsformstück (5) direkt auf die Druckverteilungsstücke (4) aufgeschrumpft ist.

8. Wandlerelement nach einem der vorhergehenden Ansprüche, dadurch gekennzeichnet, daß das Kompressionsformstück (5) einen Dehnschlitz (52) aufweist und mittels eines außen umgelegten Schrumpfringes (50) auf die Druckverteilungsstücke (4) aufgeschrumpft ist.

9. Wandlerelement nach einem der vorhergehenden Ansprüche, dadurch gekennzeichnet, daß das Kompressionsformstück (5) einen Umfangsflansch (8) zur Befestigung in einem Aufnehmergehäuse (20) aufweist.

10. Wandlerelement nach einem der vorhergehenden Ansprüche, dadurch gekennzeichnet, daß das Kompressionsformstück (5) aus einer Schwermetallegierung besteht.

11. Wandlerelement nach Anspruch 6, dadurch gekennzeichnet, daß zwischen Träger (3) und Paßkolben (2) ein erweiterter Umfangsflansch (32) angeformt ist, an dem eine Abschirmhaube (33) für die elektrische Abschirmung der Anord-nung aus Kompressionsformstück (5), Druckver-teilungsstücken (4), Piezoplatten (6) und Träger (3) befestigbar ist.

12. Wandlerelement nach Anspruch 6 oder 11, dadurch gekennzeichnet, daß der Paßkolben (2) mit einer Isolierschicht beschichtet und in einem Aufnehmergehäuse (31) in Preßsitz befestigbar ist.

13. Wandlerelement nach Anspruch 1, dadurch gekennzeichnet, daß eine Vielzahl von Piezoplatten (6) beidseitig symmetrisch zum Träger (3) angeordnet und über zwischengelegte Elektroden (7) so miteinander elektrisch verbunden sind, daß sich die Einzelladungen an den Piezoplatten aufsummieren.

14. Wandlerelement nach Anspruch 1, dadurch gekennzeichnet, daß an gegenüberliegenden Seiten des Trägers (3) je wenigstens eine Piezoplatte (6) mit Ansprechempfindlichkeit in Schubrichtung (Z) und eine Piezoplatte (60) mit Ansprechempfindlichkeit in einer dazu senkrechten Richtung (X) angeordnet ist, wobei die Piezoplatten unter Zwischenlage von Elektroden so miteinander elektrisch verbunden sind, daß Kräfte in zwei zueinander senkrechten Koordinatenrichtungen (Fig. 7) meßbar sind.

15. Wandlerelement nach Anspruch 14, gekennzeichnet durch Vorsehen von wenigstens einer weiteren Piezoplatte (61) an den gegenüberliegenden Seiten des Trägers (3) mit einer Ansprechempfindlichkeit in einer zu den beiden vorgenannten Richtungen senkrechten Richtung (Y) zur Messung von Kräften in drei zueinander senkrechten Koordinatenrichtungen (X, Y, Z) (Fig. 7).

16. Wandlerelement nach Anspruch 1, dadurch gekennzeichnet, daß das Kompressionsformstück (5) als Führungskörper und/oder seismische Masse ausgebildet ist.

## Claims

1. A piezoelectric transducer element for incorporating in pressure, force or acceleration transducers, comprising at least two flat piezo plates loaded in shear mode, said piezo plates are arranged on both sides of a central support, and two pressure distributing members of a circular sector shape, which abut said piezo plates from the outside, wherein the arrangement of the pressure distributing members, the piezo plates and the support is retained under pretension by means of a shrunk-on compression form piece, characterized in that the arrangement of said pressure distributing members (4), said piezo plates (6) and said support (3) is received in a longhole (12) formed in said compression form piece (5), said longhole having rounded ends adapted to the radius of curvature of said pressure distributing members.

2. A transducer element according to claim 1, characterized in that the distance (A) of the centers of two bores forming the rounded ends of said longhole (12), is greater than the diameter (D) of said bores.

3. A transducer element according to claim 1 or 2, characterized in that the compression form piece (5) has a periphery of an essentially circular shape.

4. A transducer element according to claim 1, 2 or 3, characterized in that the pressure distributing members (4) are flattened at diametrically opposite portions.

5. A transducer element according to claim 1, 2, 3 or 4, characterized in that the central support (3) comprises a rectangular block having a central bore (9) whose diameter (d) is adjustable to obtain an optimal elastic response.

6. A transducer element according to claim 5, characterized in that a fitpiston (2) being integral with said central support (3).

7. A transducer element according to one of the preceding claims, characterized in that the compression form piece (5) is shrunk on the pressure distributing members (4) directly. .

8. A transducer element according to one of the preceding claims, characterized in that the compression form piece (5) comprises a relieve slot (52) and is shrunk on said pressure distributing members (4) by means of an annular shrink member (50) surrounding the outer periphery of said compression form piece.

9. A transducer element according to one of the preceding claims, characterized in that for mounting in a transducer housing (20) the compression form piece (5) comprises a circumferential flange (8).

10. A transducer element according to one of the preceding claims, characterized in that the compression form piece (5) is made of a heavy metal alloy.

11. A transducer element according to claim 6, characterized in that an enlarged circumferential flange (32) is integral with a location between the central support (3) and the fitpiston (2), to said circumferential flange a shielding cover (33) is adapted to be secured, said shielding cover provides for an electrical shielding of the arrangement of the compression form piece (5), the pressure distributing members (4), the piezo plates (6) and the support (3).

12. A transducer element according to claim 6 or 11, characterized in that the fitpiston (2) is plated with an insulation layer and adapted to be mounted by pressfit in a transducer housing (31).

13. A transducer element according to claim 1, characterized in that a plurality of piezo plates (6) is arranged symmetrically on both sides of the central support (3), said piezo plates by means of interposed electrodes (7) are electrically connected with each other such that the individual charges of the piezo plates sum up.

14. A transducer element according to claim 1, characterized in that on each of the opposite sides of the support (3) at least one piezo plate (6) having a sensitivity in shear direction (Z) and one piezo plate (60) having a sensitivity in a direction (X) perpendicular to the shear direction, is arranged, said piezo plates by means of interposed electrodes are electrically connected with each other, for measuring forces in two directions of coordinates perpendicular to each other.

15. A transducer element according to claim 14, characterized in that at least one additional piezo plate (61) is provided on each of said opposite sides of said support (3) having a sensitivity in a direction (Y) perpendicular to said other directions, for measuring forces in three directions of coordinates (X, Y, Z) perpendicular to each other (Fig. 7).

16. A transducer element according to claim 1, characterized in that the compression form piece (5) is formed as a guide member and/or a seismic mass.

## Revendications

1. Elément transducteur piézo-électrique destiné à être monté dans des capteurs de pression, de force ou d'accélération, comprenant au moins deux plaques piézo-électriques usinées planes et sollicitées au cisaillement, qui sont disposées de part et d'autre d'un support central, et deux éléments de répartition de pression en forme de segments circulaires reposant extérieurement contre les plaques piézo-électriques, l'ensemble constitué par les éléments de répartition de pression, les plaques piézo-électriques et le support étant assemblé avec précontrainte par une pièce de compression frettée, caractérisé en ce que l'ensemble constitué par les éléments de répartition de pression (4), les plaques piézo-électriques (6) et le support (3) est logé dans un trou oblong (12) ménagé dans la pièce de compression (5) et qui présente des extrémités rondes adaptées au rayon de courbure des éléments de répartition de pression.

2. Elément transducteur selon la revendication 1, caractérisé en ce que la distance (A) des centres des deux perçages formant les extrémités rondes du trou oblong (12) est plus grande que leur diamètre (D).

3. Elément transducteur selon la revendication 1 ou la revendication 2, caractérisé en ce que la pièce de compression (5) présente une périphérie de forme sensiblement circulaire.

4. Elément transducteur selon la revendication 1, 2 ou 3, caractérisé en ce que les éléments de répartition de pression (4) présentent des méplats diamétralement opposés.

5. Elément transducteur selon la revendication 1, 2, 3 ou 4, caractérisé en ce que le support (3) est un bloc de forme rectangulaire et à trou central (9) dont le diamètre (d) peut être accordé à une adaption d'élasticité optimale.

6. Elément transducteur selon la revendication 5, caractérisé en ce qu'un piston d'ajustage (2) est conformé sur le support (3).

7. Elément transducteur selon l'une quelconque des revendications précédentes, caractérisé en ce que la pièce de compression (5) est frettée directement sur les éléments de répartition de pression (4).

8. Elément transducteur selon l'une quelconque des revendications précédentes, caractérisé en ce que la pièce de compression (5) présente une fente de dilatation (52) et en ce qu'elle est frettée sur les éléments de répartition de pression (4) au moyen d'une bague de frettage (50) disposée à l'extérieur.

9. Elément transducteur selon l'une quelconque des revendications précédentes, caractérisé en ce que la pièce de compression (5) présente une bride périphérique (8) pour la fixation dans un boîtier (20) de récepteur.

10. Elément transducteur selon l'une quelconque des revendications précédentes, caractérisé en ce que la pièce de compression (5) est en un alliage de métal lourd.

11. Elément transducteur selon la revendication 6, caractérisé en ce que, entre le support (3) et le piston d'ajustage (2) est rapportée une bride périphérique (32) élargie sur laquelle peut être fixée une calotte (33) de blindage servant à la protection électrique de l'ensemble constitué par la pièce de compression (5), les éléments de répartition de pression (4), les plaques piézo-électriques (6) et le support (3).

12. Elément transducteur selon la revendication 6 ou la revendication 11, caractérisé en ce que le piston d'ajustage (2) est recouvert d'une couche isolante et peut être fixé en emmanchement dur dans un boîtier (31) de récepteur.

13. Elément transducteur selon la revendication 1, caractérisé en ce qu'une multiplicité de plaques piézo-électriques (6) sont disposées symétriquement de part et d'autre du support (3) et sont reliées électriquement par des électrodes (7) interposées de telle manière que les charges unitaires des plaques piézo-électriques s'ajoutent l'une à l'autre.

14. Elément transducteur selon la revendication 1, caractérisé en ce que, sur chaque côté opposé du support (3), est disposée au moins une plaque piézo-électrique (6) à sensibilité de réponse en direction transversale (Z), et une plaque piézo-électrique (60) à sensibilité de réponse dans une direction (X) perpendiculaire à la précédente, les plaques piézo-électriques étant reliées électriquement avec interposition d'électrodes de telle manière que des forces dans deux directions de coordonnées orthogonales l'une à l'autre peuvent être mesurées (figure 7).

15. Elément transducteur selon la revendication 14, caractérisé en ce qu'on prévoit au moins une autre plaque piézo-électrique (61) sur le côté opposé du support (3), avec une sensibilité de réponse dans une direction (Y) orthogonale aux deux directions mentionnées, pour la mesure de forces dans trois directions de coordonnées (X, Y, Z) orthogonales les unes aux autres (figure 7).

16. Elément transducteur selon la revendication 1, caractérisé en ce que la pièce de compression (5) est réalisée en tant que corps de guidage et/ou masse sismique.

Fig. 1

Fig. 2

Fig. 3

Fig. 4

Fig. 5

Fig. 6

Fig. 7